# EUROPEAN PATENT SPECIFICATION

(11) **EP 2 969 392 B1**
(45) Date of publication and mention of the grant of the patent: **15.04.2020**
(21) Application number: 14712132.1
(22) Date of filing: 05.03.2014
(51) Int. Cl.: B24B 37/26

(54) **POLISHING PAD HAVING POLISHING SURFACE WITH CONTINUOUS PROTRUSIONS HAVING TAPERED SIDEWALLS**
POLIERKISSEN MIT EINER POLIEROBERFLÄCHE MIT DURCHGEHENDEN VORSPRÜNGEN MIT ABGESCHRÄGTEN SEITENWÄNDEN
TAMPON DE POLISSAGE AYANT UNE SURFACE DE POLISSAGE PRÉSENTANT DES PROTUBÉRANCES CONTINUES DONT LES PAROIS LATÉRALES PRÉSENTENT UNE SECTION DÉCROISSANTE

(30) Priority: 14.03.2013 US 201313829990
(43) Date of publication of application: 20.01.2016
(73) Proprietor: CABOT MICROELECTRONICS CORPORATION, Aurora, IL 60504 (US)
(72) Inventor: LEFEVRE, Paul, Andre, Portland, Oregon 97229 (US); ALLISON, William, C., Beaverton, Oregon 97006 (US); SIMPSON, Alexander, William, Hillsboro, Oregon 97124 (US); SCOTT, Diane, Portland, Oregon 97212 (US); HUANG, Ping, Beaverton, Oregon 97006 (US); CHARNS, Leslie, M., Portland, Oregon 97225 (US); RINEHART, James, Richard, Portland, Oregon 97219 (US); KERPRICH, Robert, Portland, Oregon 97229 (US)
(74) Representative: J A Kemp LLP
(86) International application number: PCT/US2014/020754
(87) International publication number: WO 2014/158892

(56) References cited:
- DE-B4- 10 085 092
- US-A- 5 632 790
- US-A- 5 882 251
- US-A1- 2003 114 084
- US-A1- 2011 171 883
- US-B1- 7 238 093

## Description

### TECHNICAL FIELD

Embodiments of the present invention are in the field of chemical mechanical polishing (CMP) and, in particular, polishing pads having a polishing surface with continuous protrusions having tapered sidewalls.

### BACKGROUND

Chemical-mechanical planarization or chemical-mechanical polishing, commonly abbreviated CMP, is a technique used in semiconductor fabrication for planarizing a semiconductor wafer or other substrate.

The process involves use of an abrasive and corrosive chemical slurry (commonly a colloid) in conjunction with a polishing pad and retaining ring, typically of a greater diameter than the wafer. The polishing pad and wafer are pressed together by a dynamic polishing head and held in place by a plastic retaining ring. The dynamic polishing head is rotated during polishing. This approach aids in removal of material and tends to even out any irregular topography, making the wafer flat or planar. This may be necessary in order to set up the wafer for the formation of additional circuit elements. For example, this might be necessary in order to bring the entire surface within the depth of field of a photolithography system, or to selectively remove material based on its position. Typical depth-of-field requirements are down to Angstrom levels for the latest sub-50 nanometer technology nodes.

The process of material removal is not simply that of abrasive scraping, like sandpaper on wood. The chemicals in the slurry also react with and/or weaken the material to be removed. The abrasive accelerates this weakening process and the polishing pad helps to wipe the reacted materials from the surface. In addition to advances in slurry technology, the polishing pad plays a significant role in increasingly complex CMP operations.

US 2003/114084 A1 discloses method and apparatus for polishing substrates.

US 5,632,790 discloses an injection molded abrasive article and process.

However, additional improvements are needed in the evolution of CMP pad technology.

### SUMMARY

According to an aspect of the present invention there is provided a polishing pad as defined in claim 1.

Additional aspects of the invention are set out in the dependent claims.

### BRIEF DESCRIPTION OF THE DRAWINGS

Figure 1 illustrates a top-down plan view of a concentric circular groove pattern disposed in the polishing surface of a conventional polishing pad.
Figure 2A illustrates a top-down plan view of a protrusion pattern disposed in the polishing surface of a polishing pad, in accordance with an embodiment not of the present invention.
Figure 2B is an enlarged view of the protrusion pattern of a portion of Figure 2A.
Figure 2C is a comparison cross-sectional view taken along the a-a' axis of Figure 2B, in order to compare cylindrical protrusions with the examples shown in Figures 2D-2G.
Figure 2D is a cross-sectional view taken along the a-a' axis of Figure 2B for protrusions having planar sidewalls.
Figure 2E is a cross-sectional view taken along the a-a' axis of Figure 2B for protrusions having curved sidewalls.
Figure 2F is a cross-sectional view taken along the a-a' axis of Figure 2B for protrusions having stepped sidewalls.
Figure 2G is a cross-sectional image taken along the a-a' axis of Figure 2B for protrusions having globally outwardly sidewalls with an undercut portion.
Figure 3A illustrates an exemplary center field for the polishing pad of Figures 2A-2G where the polishing surface includes a button region having a triangular clocking mark on one side of the hexagonal shape of the button.
Figure 3B illustrates an exemplary outer field for the polishing pad of Figures 2A-2G where the polishing surface includes a solid ring encompassing the plurality of protrusions at an outer most edge of the polishing side of the polishing body.
Figure 4 illustrates options for the polishing surface shape of a protrusion such as a circle ("A"), an oval ("B"), a triangle ("C"), a pentagon ("D") and a hexagon ("E"), each having tapered sidewalls, in accordance with an embodiment of the present invention.
Figure 5A illustrates a pattern of protrusions in a hexagonal packed arrangement, in accordance with an embodiment of the present invention.
Figure 5B illustrates a pattern of protrusions in a square packed arrangement, in accordance with an embodiment not of the present invention.
Figure 5C illustrates a pattern of protrusions in a generally square packed arrangement, with larger spacing between groupings of protrusions, not in accordance with an embodiment of the present invention.
Figure 6A illustrates a pattern of protrusions in a generally hexagonal packed arrangement, with larger spacing between substantially square or rectangular shaped groupings of protrusions, in accordance with an embodiment of the present invention.
Figure 6B illustrates a pattern of protrusions in a generally hexagonal packed arrangement, with larger spacing between rhombic shaped groupings of protrusions, in accordance with an embodiment of the present invention.
Figure 6C illustrates a pattern of protrusions in a generally hexagonal packed arrangement, with larger spacing between triangular shaped groupings of protrusions, in accordance with an embodiment of the present invention.
Figure 6D illustrates a pattern of protrusions in a generally hexagonal packed arrangement, with larger spacing between strip-based shaped groupings of protrusions, in accordance with an embodiment of the present invention.
Figure 7 illustrates a pattern of protrusions in a generally hexagonal packed arrangement, with larger spacing between rhombic shaped groupings of protrusions, the rhombic shaped groupings arranged in sub-patterns, in accordance with an embodiment of the present invention.
Figure 8A illustrates an angled plan view of a modified quadrilateral protrusion pattern disposed in the polishing surface of a polishing pad, not in accordance with an embodiment of the present invention.
Figure 8B illustrates an exemplary center field for the polishing pad of Figure 8A where the polishing surface includes a button region having a modified square shape.
Figure 8C illustrates an exemplary outer field for the polishing pad of Figure 8A where the polishing surface includes a solid ring encompassing the plurality of modified quadrilateral protrusions at an outer most edge of the polishing side of the polishing body.
Figure 9A illustrates options for the polishing surface shape of a modified quadrilateral polishing protrusion, such as a square with four rounded corners, a square with four notched corners, and a square with four arced sides, in accordance with an embodiment of the present invention.
Figure 9B illustrates options for the quadrilateral shape used as a foundation for a modified quadrilateral polishing protrusion, such as a modified-square shape, a modified-rectangular shape, a modified-rhombus shape, and a modified-trapezoidal shape, in accordance with an embodiment of the present invention.
Figure 10 illustrates a top-down plan view of a protrusion pattern, the pattern interrupted by a local area transparency (LAT) region and/or an indication region, disposed in the polishing surface of a polishing pad, not in accordance with an embodiment of the present invention.
Figures 11A-11F illustrate cross-sectional views of operations used in the fabrication of a polishing pad, in accordance with an embodiment of the present invention.
Figure 12 illustrates an isometric side-on view of a polishing apparatus compatible with a polishing pad having a polishing surface with continuous protrusions having tapered sidewalls, in accordance with an embodiment of the present invention.

### DETAILED DESCRIPTION

Polishing pads having a polishing surface with continuous protrusions having tapered sidewalls are described herein. In the following description, numerous specific details are set forth, such as specific polishing pad designs and compositions, in order to provide a thorough understanding of embodiments of the present invention. It will be apparent to one skilled in the art that embodiments of the present invention may be practiced without these specific details. In other instances, well-known processing techniques, such as details concerning the combination of a slurry with a polishing pad to perform chemical mechanical planarization (CMP) of a semiconductor substrate, are not described in detail in order to not unnecessarily obscure embodiments of the present invention. Furthermore, it is to be understood that the various embodiments shown in the figures are illustrative representations and are not necessarily drawn to scale.

Polishing pads for polishing substrates in CMP operations typically include at least one surface with physical grooves or protrusions formed therein. The grooves or protrusions may be arranged to balance an appropriate amount of surface area for polishing the substrate while providing a reservoir for slurry used in the CMP operation. In accordance with embodiment of the present invention, protrusion patterns are described for polishing surfaces of polishing pads. In the embodiment of the invention, each protrusion has a flat surface or plane distal from the polishing body of a polishing bad, with sidewalls that taper outwardly from the flat surface or plane toward the polishing body.

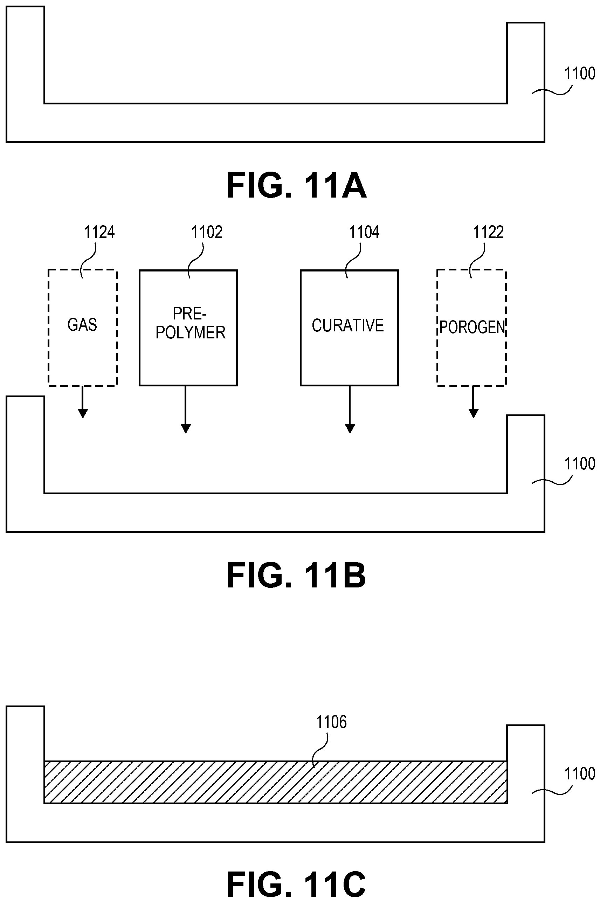

Protrusion patterns described herein may provide benefits for, or may be advantageous over prior art polishing pads for, polishing substrates in a CMP operation using slurry. For example, advantages of protrusion patterns described herein may include (a) improved averaging of a slurry-based polish process across a polished substrate as the polishing pad is rotated relative to a polished substrate, and (b) improved slurry retention on the polishing pad relative to pads with conventional groove or protrusion patterns. Furthermore, the outwardly tapered sidewalls of the may aid with a demolding process during fabrication of the polishing pad, as described in greater detail below in association with Figures 11A-11F. Generally, embodiments of the present invention include the use of protrusion features having relatively similar values for all dimensions within a polishing plane of the polishing surface. The protrusions may be formed by a molding process, as such protrusion shapes would typically otherwise be impractical to form by cutting a pattern into a polishing surface.

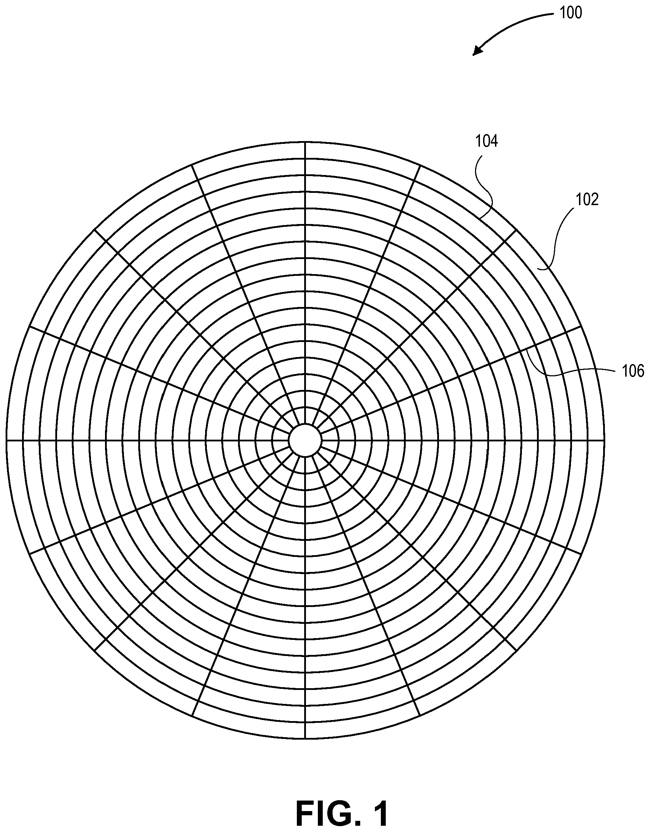

To provide context, conventional polishing pads typically have concentric circular groove patterns with radial grooves there through. For example, Figure 1 illustrates a top-down plan view of a concentric circular groove pattern disposed in the polishing surface of a conventional polishing pad.

Referring to Figure 1, a polishing pad 100 includes a polishing body having a polishing surface 102 and a back surface (not shown). The polishing surface 102 has a pattern of grooves of concentric circles 104. The pattern of grooves also includes a plurality of radial grooves 106 continuous from the inner most circle to the outer most circle, as depicted in Figure 1. The potential drawbacks of such a groove pattern can include poor averaging of slurry distribution across large concentric grooves and/or slurry loss by drainage along radial grooves.

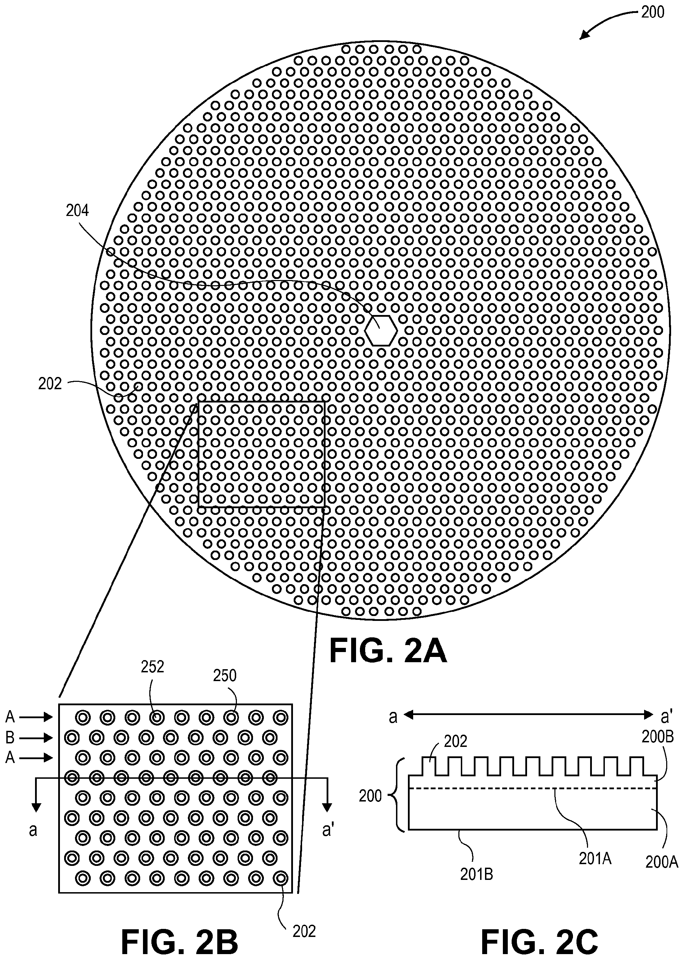

In contrast to Figure 1, and as exemplified in Figure 2A below, embodiments of the present invention include patterns of protrusions which are spaced narrowly relative to conventional groove spacing. Furthermore, all dimensions of the protrusions in a plane of the polishing surface are relatively similar and, hence, each protrusion can be effective for providing consistent localized polishing characteristics. By avoiding conventional grooving, slurry retention on the polishing pad may be improved by the use of such protrusions.

In an aspect of the present invention, a polishing pad may be fabricated with a polishing surface having a pattern of continuous protrusions thereon, each protrusion having tapered sidewalls. As an example, Figure 2A illustrates a top-down plan view of a protrusion pattern disposed in the polishing surface of a polishing pad. Figure 2B is an enlarged view of the protrusion pattern of a portion of Figure 2A showing tapered sidewalls from a plan view perspective.

Referring to the enlarged view of Figure 2B, each protrusion 202 is larger at the body of the polishing pad (e.g., seen as outer circle 250) and smaller away from the body of the polishing pad (e.g., seen as inner circle 252). That is, the inner circle 252 is an outermost surface of the protrusion 202. As such, each protrusion 202 is not cylindrical. For comparative purposes, Figure 2C is a hypothetical cross-sectional view taken along the a-a' axis of Figure 2B in the case that the protrusions are cylindrical, i.e., in the case that inner and outer circles 250 and 252, respectively, would not be viewed in the plan view of Figure 2B. A cylindrical protrusion is one that maintains a same shape and shape size in a vertical direction (e.g., has essentially or precisely vertical sidewalls) throughout the protrusions.

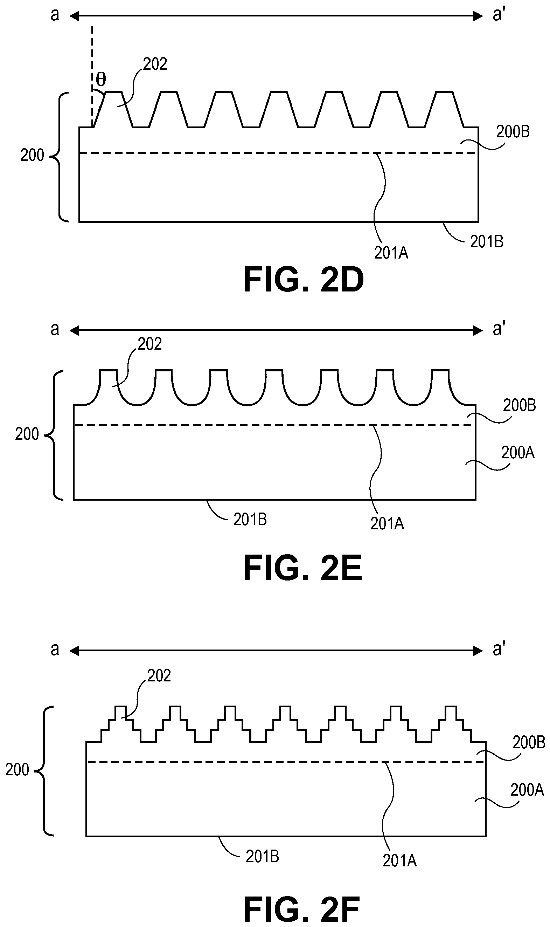

By contrast to Figure 2C, protrusions described in association with embodiments of the present inventions can be viewed as non-cylindrical. That is, although each protrusion 202 maintains a same shape in a vertical direction, each protrusion 202 does not maintain a same shape size (e.g., has essentially or precisely vertical sidewalls) throughout the protrusions and therefore does not have entirely vertical sidewalls. Exemplary embodiments of such non-cylindrical protrusions include those illustrated in Figures 2D-2G, which are protrusions having outwardly tapered sidewalls.

In a first example, Figure 2D is a cross-sectional view taken along the a-a' axis of Figure 2B for protrusions having planar sidewalls, in accordance with an embodiment of the present invention. Referring to Figure 2D, each protrusion 202 has an upper flat surface (i.e., a flat surface distal from the polishing body) and planar sidewalls tapered outwardly from the flat surface toward the polishing body. The planar sidewalls are tapered with an angle, θ, relative to normal of the polishing surface of the polishing body (shown as the dashed vertical line in Figure 2D). In one such embodiment, the sidewalls are tapered with an angle, θ, of less than approximately 30 degrees to normal of the polishing surface of the polishing body. In a specific such embodiment, the sidewalls are tapered with an angle, θ, approximately in the range of 0.1 - 10 degrees to normal of the polishing surface of the polishing body. The protrusions of Figure 2D can be viewed as conical protrusions in that the sidewalls can be viewed as a plurality of imaginary lines that intersect at a point above each protrusion.

In a second example, Figure 2E is a cross-sectional view taken along the a-a' axis of Figure 2B for protrusions having curved sidewalls, in accordance with another embodiment of the present invention. Referring to Figure 2E, each protrusion 202 has an upper flat surface (i.e., a flat surface distal from the polishing body) and curved sidewalls tapered outwardly from the flat surface toward the polishing body. In an embodiment, the curvature has a profile such as, but not limited to, a circular portion profile, an oval portion profile, or a profile filed based on an exponential decay curve.

In a third example, Figure 2F is a cross-sectional view taken along the a-a' axis of Figure 2B for protrusions having stepped sidewalls, in accordance with another embodiment of the present invention. Referring to Figure 2F, each protrusion 202 has an upper flat surface (i.e., a flat surface distal from the polishing body) and stepped sidewalls tapered outwardly from the flat surface toward the polishing body. In Figure 2F, two steps along each sidewall are depicted. However, in other embodiments, a single step, or more than two steps, may be includes in each sidewall profile.

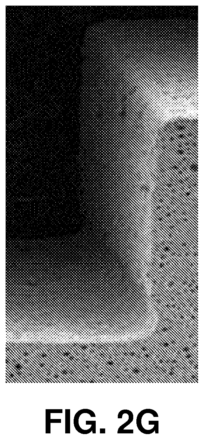

It is to be understood that examples of outward tapering within the spirit and scope of embodiments of the present invention, are not limited to those shown in examples 2D-2F. Furthermore, the sidewalls may be generally outwardly tapering but not entirely outwardly tapering. For example, in one embodiment, a portion of the sidewall actually undercuts the upper flat surface of the protrusion. However, in that embodiment, globally, the sidewall tapers outwardly from the upper flat surface of the protrusion. As an example, Figure 2G is a cross-sectional image taken along the a-a' axis of Figure 2B for protrusions having globally outwardly sidewalls with an undercut portion, in accordance with another embodiment of the present invention.

Referring again to Figures 2A and 2D-2G, a polishing pad 200 includes a polishing body (shown as 200A in Figures 2D-2G). The polishing body has a polishing side 201A opposite a back surface 201B. The polishing pad 200 also includes a polishing surface, as seen in the top-down view of Figure 2A and referred as 200B of Figures 2D-2G. The polishing surface has a plurality of protrusions 202 continuous with the polishing side 201A of the polishing body 200A. As mentioned above, referring to Figure 2B, an enlarged view of field detail of exemplary protrusions 202 is provided. The portion of the pad 200 shown in Figures 2D-2G represents exemplary cross-sectional views of the portion enlarged in Figure 2B.

Referring again to Figures 2D-2G, the protrusions 202 having tapered sidewalls are continuous in the sense that they form a common unified polishing surface layer, best seen as a unified region 200B. The continuous nature of the protrusions is in contrast to discrete protrusions, such as affixed tiles, that are in no way connected to one another on a surface to which they are affixed. Furthermore, in one embodiment, the polishing surface 200B and the polishing body are unified. In that case, the dotted line showing separation between regions 200A and 200B is provided merely as a visual aid for conceptualizing the difference between the polishing body and polishing surface regions of a polishing pad. Furthermore, in one embodiment, the polishing body 200A and polishing surface 200B are together both homogeneous and unitary. In a specific exemplary embodiment, the polishing body 200A and polishing surface 200B are composed of a same molded polyurethane material, exemplary details of which are provided below.

Referring again to Figure 2B, the plurality of protrusions 202 having tapered sidewalls may be arranged in a global pattern with at least some level of repetition. For example, in one embodiment as illustrated in Figure 2B, the plurality of protrusions 202 is arranged in a hexagonal packed patterned in that rows of the protrusions are staggered in an ABA arrangement. Other exemplary arrangements are described in greater detail below.

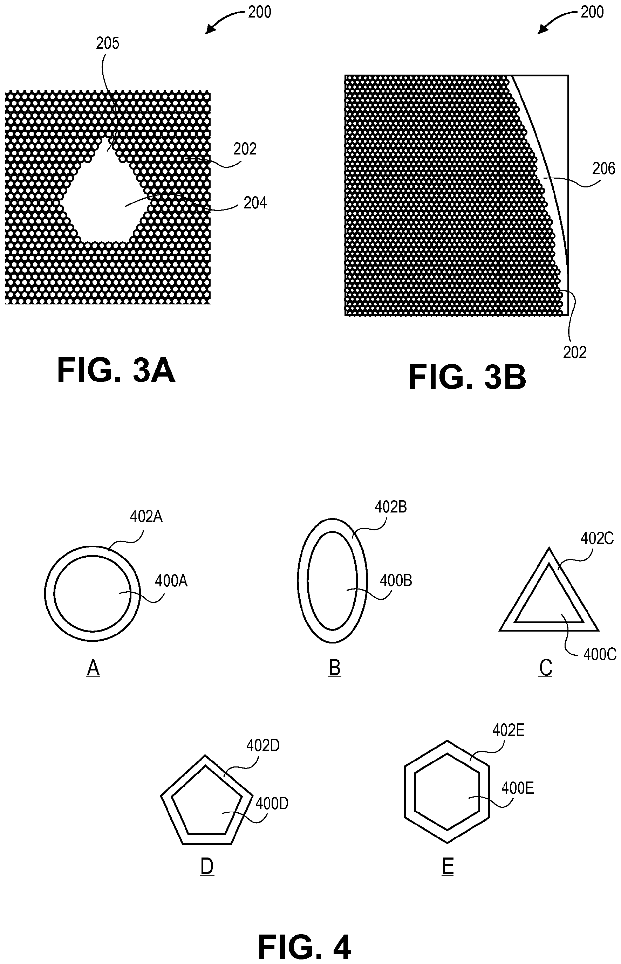

Referring again to Figure 2A, the polishing pad 200 may include a central button 204. The button 204 can be a raised portion of pad material (e.g., co-planar and continuous with the protrusions 202) that provides a region for pad property testing. In one such embodiment, polishing is not performed in the region of button 204. The button 204 may a shape compatible with the overall pattern of protrusions 202. In an exemplary embodiment, referring to Figures 2A and 3A (the latter illustrating a possible embodiment for a center field portion of pad 200), the plurality of protrusions 202 has a global hexagonal packed arrangement, and button 204 has a hexagonal shape. Furthermore, the button 204 may include a clocking feature which provides pad fabrication information and/or alignment information for polishing or for adhering a pad to a platen. In a specific such embodiment, referring to Figure 3A, the button region 204 further includes a triangular clocking mark on one side of the hexagonal shape. In a particular embodiment, the hexagonal center button 204 is approximately 2.5 cm (1 inch) across, and the clocking mark 205 is triangular on one face of the hexagon. In an embodiment, the central button 204 also has tapered sidewalls.

The outer portion of polishing pad 200 may be tailored for specific polishing purposes. For example, Figure 3B illustrates an exemplary outer field for the polishing pad of Figures 2A-2G where the polishing surface includes a solid ring 206 encompassing the plurality of protrusions 202 having tapered sidewalls at an outer most edge of the polishing side of the polishing body, in accordance with an embodiment of the present invention. In a specific embodiment as depicted in Figure 3B, a hexagonal-packed pattern of protrusions 202 terminates proximate to the ring 206 in a staggered arrangement. In a particular embodiment, the solid outer ring 206 has an average width of approximately 125 mils. In an embodiment, the inner edge of the solid outer ring 206 is shaped to avoid large down space, while providing an edge of the pad 200 that is continuous and has a dam effect on slurry. Overall, however, the solid ring may have an irregular shape that follows the contour of the pattern of protrusions, as is depicted in figure 3B. In an embodiment, the solid outer ring 206 also has tapered sidewalls.

Referring again to Figures 2A, 2B, 3A and 3B, each of the protrusions 202 are depicted to have a circular shape in a plane of the polishing surface of the polishing pad 200. However, other shapes may also be suitable for providing an effective polishing surface. Referring to Figure 4, in an embodiment, each of the plurality of protrusions 202 of polishing pad 200 has a shape in an outermost plane of the polishing surface such as, but not limited to, a circle ("A" from Figure 4; also used as exemplary protrusion in Figures 2A, 2B), an oval ("B" from Figure 4), or a polygon having five or more sides (e.g., the triangle "C" from Figure 4, the pentagon "D" from Figure 4, or the hexagon "E" from Figure 4; also, although not shown, a square or rectangular shape is used in another embodiment). It is noted that all of these options for the protrusions 202 can have a cross-sectional shape as viewed in Figures 2D, 2E, 2F or 2G. In an embodiment, each protrusion 202 is larger at the body of the polishing pad (e.g., seen as outer shape 402A, 402B, 402C, 402D or 402E) and smaller away from the body of the polishing pad (e.g., seen as inner shape 400A, 400B, 400C, 400D or 400E, respectively). That is, the inner shape is an outermost surface of the protrusion 202. The protrusion has sidewalls which taper outwardly to the outer shape, proximate to the body of the polishing pad. As such, each protrusion shown in Figure 4 is not cylindrical.

Furthermore, in an embodiment, the protrusions described herein are distinguished from a large arcing groove type polishing feature. In one such embodiment, the protrusion shape is one that would otherwise be impractical to achieve by merely cutting a pattern into a polishing surface, such as protrusions having vertical sidewalls. For example, in an embodiment, the protrusions 202 having tapered sidewalls are formed by a molding process, as described in greater detail below.

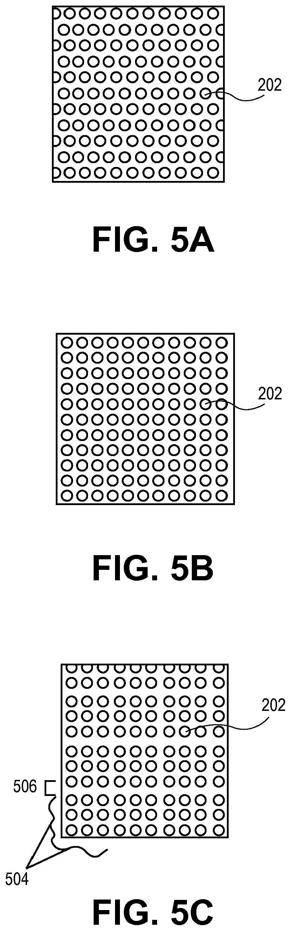

Referring again to Figures 2A, 2B, 3A and 3B, the pattern of the plurality of protrusions 202 having tapered sidewalls is not limited to a hexagonal packed arrangement. Other arrangements may also provide a packing of protrusions having tapered sidewalls suitable for polishing a substrate or wafer. Referring to Figure 5B, in an embodiment not of the invention, a plurality of protrusions 202 is arranged in a square-packed pattern, in that all successive rows of protrusions are aligned with one another. This is in contrast to the staggered arrangement resulting from hexagonal packing, illustrated again in Figure 5A for comparison. In other embodiments not of the invention, the protrusions 202 are arranged in a randomized pattern, with effectively no long range pattern repetition.

Additionally, the spacing between protrusions need not always be the same. For example, groupings of tighter spaced protrusions may be arranged with larger spacings between groupings in order to provide channels between the grouping. That is, in one embodiment, a pattern of protrusions is arranged to have a plurality of high density regions having less spacing between adjacent protrusions within a high density region as compared to spacing between adjacent protrusions of adjacent high density regions. In an exemplary embodiment not of the invention, Figure 5C illustrates a pattern of protrusions 202 in a generally square packed arrangement, with larger spacing between groupings of protrusions. Referring to Figure 5C, a grouping 504 has less spacing between protrusions 202 within grouping 504 than the spacing 506 between adjacent groupings. In the specific example, of Figure 5C, an XY channel arrangement results between groupings. The inclusion of such channels may be used for slurry transport or for modifying other polishing characteristics of a polishing pad. Furthermore, in an embodiment, since the protrusions are molded and not cut, the spacing between grouping can be varies beyond simple removal of one row or column of protrusions between grouping, as would other wise be required for cutting of a pattern.

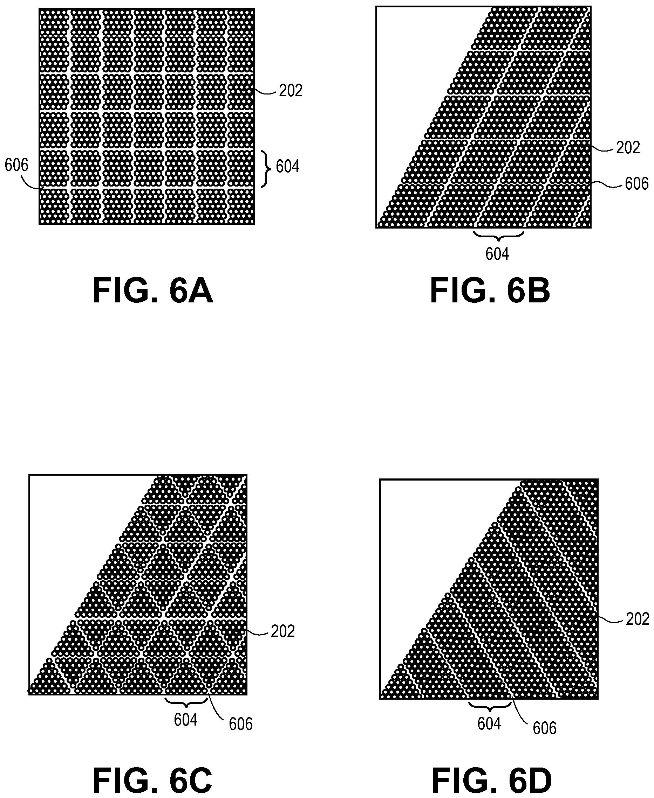

With reference to the description of Figure 5C, groupings of protrusions 202, with larger spacing between such groupings, may also be based on a generally hexagonal packed arrangement of protrusions. For example, in an embodiment, a pattern of protrusions 202 having tapered sidewalls includes high density regions 604 are arranged in a hexagonal-packed pattern with larger spacings 606 between such high density groupings (e.g., ultimately forming channels). The high density regions can, in one embodiment, have a general shape such as, but not limited to, a substantially square or rectangular shape with spacing between each of the high density regions based on an X-Y grid pattern (Figure 6A), a rhombic shape (Figure 6B), a triangular shape (Figure 6C), or a strip-based shape (Figure 6D).

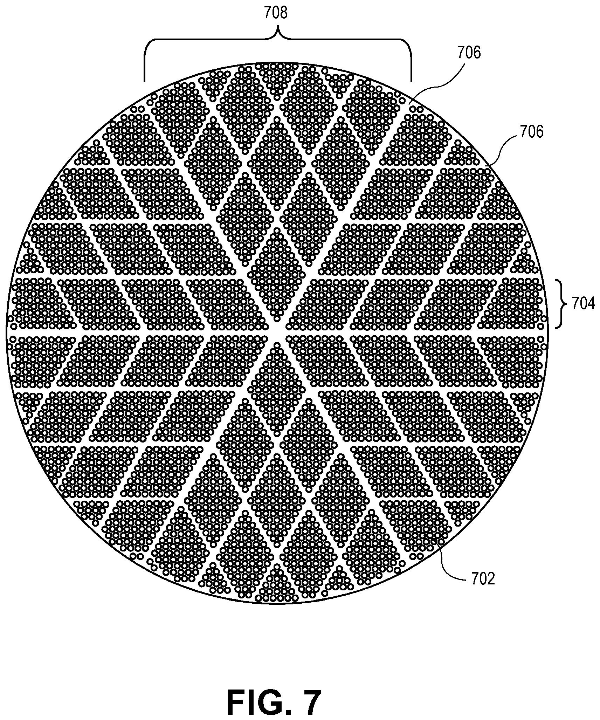

The above described high density regions can have sub-patterns that combine to form one larger pattern based on pad orientation. In an exemplary embodiment, Figure 7 illustrates a pattern of protrusions 202 having tapered sidewalls in a generally hexagonal packed arrangement, with larger spacing 706 between rhombic shaped groupings 704 of protrusions, the rhombic shaped groupings arranged in sub-patterns 708, in accordance with an embodiment of the present invention. Effectively, a sub-pattern 708 of the high density regions 704 is repeated every 60 degree rotation of the polishing pad. The result is a pattern that originates from a central point 710, as depicted in Figure 7.

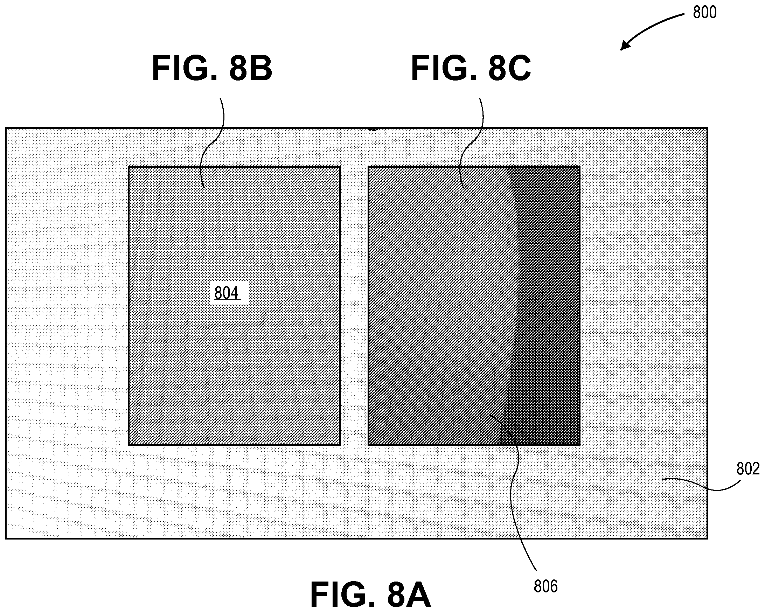

In another aspect of the present invention, a polishing pad may be fabricated with a polishing surface having a pattern of continuous protrusions based on a modified quadrilateral shape thereon, each protrusion having sidewalls tapered outwardly from a top plane toward the polishing surface. As an example, Figure 8A illustrates an angled plan view of a modified quadrilateral protrusion pattern disposed in the polishing surface of a polishing pad, not in accordance with an embodiment of the present invention. Referring to Figure 8A, a polishing pad 800 includes a polishing body and a polishing surface having a plurality of protrusions 802 continuous with the polishing side of the polishing body. Each protrusion 802 has a modified-quadrilateral polygon shape in a plane of the polishing surface. In one embodiment, although not depicted as such, each protrusion 802 has sidewalls tapered outwardly from the plane toward the polishing body.

Similar to the protrusions 202 of pad 200, e.g., as described in association with Figures 2C-2G, the protrusions 802 of polishing pad 800 are continuous in the sense that they form a common unified polishing surface layer. The continuous nature of the protrusions 802 is in contrast to discrete protrusions, such as affixed tiles, that are in no way connected to one another on a surface to which they are affixed. Furthermore, in one embodiment, the polishing surface and the polishing body of polishing pad 800 are unified. Furthermore, in one embodiment, the polishing body and polishing surface of polishing pad 800 are together both homogeneous and unitary, exemplary details of materials for which are provided below.

Referring again to Figure 8A, the plurality of protrusions 802 may be arranged in a global pattern with at least some level of repetition. For example, in one embodiment as illustrated in Figure 8A, the plurality of protrusions 802 is arranged in a square packed patterned in that rows of the protrusions 802 form an XY grid arrangement. Other exemplary arrangements may be similar to those described above in association with polishing pad 200. For example, similar to Figures 5C, 6A-6D and 7, in one embodiment, the plurality of protrusions 802 is arranged in a plurality of high density regions having less spacing between adjacent protrusions within a high density region than between adjacent protrusions of adjacent high density regions. In a specific such embodiment, each of the high density regions is substantially square or rectangular, and spacing or channels between each of the high density regions of the plurality of high density regions forms an X-Y grid pattern. In another embodiment, the plurality of protrusions 802 has a hexagonal packed or a randomized pattern.

Referring now to inset Figure 8B, the polishing pad 800 may include a central button 804. The button 804 can be a raised portion of pad material (e.g., co-planar and continuous with the protrusions 802) that provides a region for pad property testing. In one such embodiment, polishing is not performed in the region of button 804. The button 804 may a shape compatible with the overall pattern of protrusions 802. In an exemplary embodiment, referring to Figure 8B, the plurality of protrusions 802 has a global square packed (or XY grid) arrangement, and button 804 has a modified square shape (in this case, a square having four notched corners). Furthermore, although not depicted the button 204 may include a clocking feature which provides pad fabrication information and/or alignment information for polishing or for adhering a pad to a platen. In one such embodiment, the button region 804 further includes a clocking mark on one side of the modified square shape. In an embodiment, although not depicted as such, the button region 804 also has tapered sidewalls.

Referring now to inset Figure 8C, the outer portion of polishing pad 800 may be tailored for specific polishing purposes. For example, 8C provides an exemplary outer field for the polishing pad 800 where the polishing surface includes a solid ring 806 encompassing the plurality of protrusions 802 at an outer most edge of the polishing side of the polishing body, in accordance with an embodiment of the present invention. The solid ring 806 is continuous with the polishing side of the polishing body, and a continuous groove is disposed between the solid ring and the plurality of protrusions 802. The continuous edge of the ring 806 can provide a good location for sealing for backside pad cutting and/or providing an edge of the pad 800 that is continuous and has a dam effect on slurry. In an embodiment, although not depicted as such, the ring 806 also has tapered sidewalls.

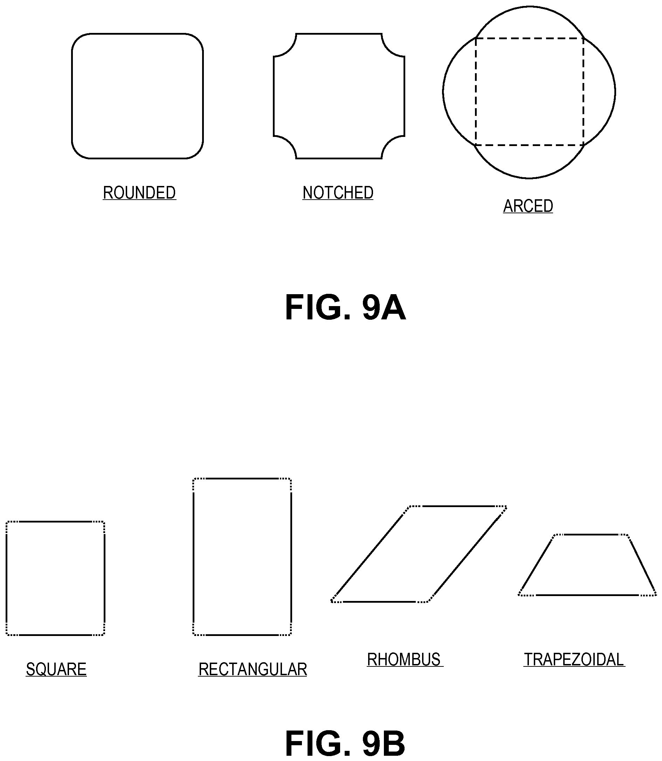

Referring again to Figures 8A-8C, each of the protrusions 802 are depicted to have a square shape will all four corners rounded shape in a plane of the polishing surface of the polishing pad 800. However, other modified quadrilateral shapes may also be suitable for providing an effective polishing surface. The modified quadrilateral shape describes the nature of the protrusions having approximately the same dimension in all 360 degrees of the protrusion shape. This is, the protrusions 802 are distinguished from a large arcing groove type polishing feature. In one embodiment, the modified quadrilateral protrusion shape is one that would otherwise be impractical to achieve by merely cutting a pattern into a polishing surface, e.g., in some form of an XY grid cutting approach (such as tiles or protrusions having basic square or basic rectangular geometries as viewed from the top-down of the protrusion). For example, Referring to Figure 9A, in an embodiment, each of the plurality of modified quadrilateral protrusions 802 of polishing pad 800 has a modification in a plane of the polishing surface such as, but not limited to, one or more rounded corners (a square with four rounded corners is shown in Figure 9A), a one or more notched corners (a square with four notched corners is shown in Figure 9A), or one or more arced sides (a square with four arced sides is shown in Figure 9A). In one such embodiment, the modified quadrilateral protrusions 802 are formed by a molding process, as described in greater detail below.

As mentioned briefly above, the modified quadrilateral shape of protrusions 802 can be one which has one or more corners modified. Referring to Figure 9B, quadrilateral shapes used as a foundation may include, but are not limited to, a modified-square shape, a modified-rectangular shape, a modified-rhombus shape, or a modified-trapezoidal shape. It is noted that the corners of the quadrilateral shapes of Figures 9B are depicted with dotted lines, indication that shape modification (such as rounding or notching) may be situated at one or more of these locations. Other options include arcing one or more of the sides of the shapes, as described in association with Figure 9A. Furthermore, in one embodiment, the modified quadrilateral protrusions have outwardly tapering sidewalls as they approach the polishing pad body. That is, in an embodiment, each protrusion of Figures 9A and 9B is larger at the body of the polishing pad and smaller away from the body of the polishing pad. As such, in that embodiment, each protrusion is not cylindrical.

In an embodiment, polishing pads described herein, such as polishing pad 200 or 800, or the above described variations thereof, each of the polishing protrusions (e.g., the polishing protrusions described in association with Figures 2A-2G, 3A, 3B, 4, 5A-5C, 6A-6D, 7, 8A-8C, 9A and 9B) has a maximum lateral dimension approximately in the range of 1 - 30 millimeters at the polishing body. For example, in the case of a circular shaped protrusion, the maximum lateral dimension is the diameter of the circle at the polishing body. In the case of a modified square shape, the maximum lateral dimension is the dimension spanning the modified square shape in the plane of the polishing surface, and at the polishing body. In an embodiment, a spacing between protrusions is approximately in the range of 0.1 - 3 millimeters at the polishing surface, and can be the same across the pad (e.g., as described in association with Figure 5B) or can vary across the pad (e.g., as described in association with Figure 5C). The number of protrusions on a polishing surface can vary by application and/or pad size. In an exemplary embodiment, a polishing pad having a diameter approximately in the range of 73.6 - 81.3 cm (29 - 32 inches) at the polishing surface includes approximately between 50,000 and 200,000 protrusions. In an embodiment, the height of each protrusion on a polishing pad is approximately in the range of 0.5 - 1 millimeter.

Within a same polishing surface of a polishing pad, in an embodiment, the above described protrusions need not all be same size. For example, in one embodiment, in a same polishing surface, a first portion of protrusions has a first maximum lateral dimension at the polishing body, while each protrusion of a second portion of protrusions has a second, different, maximum lateral dimension at the polishing body. In a specific and exemplary such embodiment, a pattern of a plurality of protrusions includes a protrusion having a maximum lateral dimension of approximately 10 millimeters at the polishing body surrounded by a plurality of protrusions each having a maximum lateral dimension of approximately 1 millimeter at the polishing body.

Additionally or alternatively, within a same polishing surface of a polishing pad, in an embodiment, the above described protrusions need not all have a same shape. For example, in one embodiment, each protrusion of a first portion of protrusions on the polishing surface has a first shape in a plane of the polishing surface, while each protrusion of a second portion of protrusions has a second, different, shape in the plane of the polishing surface. Furthermore or alternatively, within a same polishing surface of a polishing pad, in an embodiment, the above described protrusions need not all have a same height. However, the highest point of all protrusions may be co-planar (e.g., the portions of each of the protrusions that is in contact with a wafer or substrate during polishing forms a substantially planar surface). For example in one embodiment, each protrusion of a first portion of protrusions has a first height from the polishing body, while each protrusion of a second portion of protrusions has a second, different, height from the polishing body. Nonetheless, all of the protrusions from the first and second portions are substantially co-planar distal from the polishing body. Such an arrangement may enable formation of reservoirs or other slurry handling features within the polishing pad while maintaining a planar wafer or contact surface (e.g., at an outer most surface of the protrusions).

In an embodiment, polishing pads described herein, such as polishing pad 200 or 800, or the above described variations thereof, the total surface area of the plurality of protrusions is a portion approximately in the range of 40 - 80 % of the total surface area of the polishing side of the polishing body. In a first exemplary embodiment, protrusion that are hexagonal packed circular protrusions (e.g., as described in association with Figures 2B and 5A) having a diameter of approximately 80 mils and a spacing of approximately 20 mils provide a contact area of protrusion surface of approximately 58%. In a second exemplary embodiment, protrusion that are square packed circular protrusions (e.g., as described in association with Figure 5B) having a diameter of approximately 80 mils and a spacing of approximately 16 mils provide a contact area of protrusion surface of approximately 54.5%. In a third exemplary embodiment, protrusion that are square packed circular protrusions and having XY channels between regions of protrusions (e.g., as described in association with Figure 5C) having a diameter of approximately 80 mils and a spacing of approximately 16 mils, or approximately 35 mils between regions at the XY channels, provides contact area of protrusion surface of approximately 48%. In a fourth exemplary embodiment, protrusions that are molded squares with rounded corners packed in an XY grid (e.g., as described in association with Figure 8A) having a maximum lateral dimension of approximately 120 mils and a spacing of approximately 40 mils provides a contact area of protrusion surface of approximately 54.3%.

In an embodiment, polishing pads described herein, such as polishing pad 200 or 800, or the above described variations thereof, are suitable for polishing substrates. The substrate may be one used in the semiconductor manufacturing industry, such as a silicon substrate having device or other layers disposed thereon. However, the substrate may be one such as, but not limited to, a substrates for MEMS devices, reticles, or solar modules. Thus, reference to "a polishing pad for polishing a substrate," as used herein, is intended to encompass these and related possibilities.

Polishing pads described herein, such as polishing pad 200 or 800, or the above described variations thereof, may be composed of a homogeneous polishing body of a thermoset polyurethane material. In an embodiment, the homogeneous polishing body is composed of a thermoset, closed cell polyurethane material. In an embodiment, the term "homogeneous" is used to indicate that the composition of a thermoset, closed cell polyurethane material is consistent throughout the entire composition of the polishing body. For example, in an embodiment, the term "homogeneous" excludes polishing pads composed of, e.g., impregnated felt or a composition (composite) of multiple layers of differing material. In an embodiment, the term "thermoset" is used to indicate a polymer material that irreversibly cures, e.g., the precursor to the material changes irreversibly into an infusible, insoluble polymer network by curing. For example, in an embodiment, the term "thermoset" excludes polishing pads composed of, e.g., "thermoplast" materials or "thermoplastics" - those materials composed of a polymer that turns to a liquid when heated and returns to a very glassy state when cooled sufficiently. It is noted that polishing pads made from thermoset materials are typically fabricated from lower molecular weight precursors reacting to form a polymer in a chemical reaction, while pads made from thermoplastic materials are typically fabricated by heating a pre-existing polymer to cause a phase change so that a polishing pad is formed in a physical process. Polyurethane thermoset polymers may be selected for fabricating polishing pads described herein based on their stable thermal and mechanical properties, resistance to the chemical environment, and tendency for wear resistance.

In an embodiment, the homogeneous polishing body, upon conditioning and/or polishing, has a polishing surface roughness approximately in the range of 1 - 5 microns root mean square. In one embodiment, the homogeneous polishing body, upon conditioning and/or polishing, has a polishing surface roughness of approximately 2.35 microns root mean square. In an embodiment, the homogeneous polishing body has a storage modulus at 25 degrees Celsius approximately in the range of 30 - 120 megaPascals (MPa). In another embodiment, the homogeneous polishing body has a storage modulus at 25 degrees Celsius approximately less than 30 megaPascals (MPa). In one embodiment, the homogeneous polishing body has a compressibility of approximately 2.5%. In one embodiment, the homogeneous polishing body has a density approximately in the range of 0.70 - 1.05 grams per cubic centimeter.

In an embodiment, polishing pads described herein, such as polishing pad 200 or 800, or the above described variations thereof, include a molded homogeneous polishing body. The term "molded" is used to indicate that a homogeneous polishing body is formed in a formation mold, as described in more detail below in association with Figures 11A-11F.

In an embodiment, polishing pads described herein, such as polishing pad 200 or 800, or the above described variations thereof, include a polishing body having a plurality of closed cell pores therein. In one embodiment, the plurality of closed cell pores is a plurality of porogens. For example, the term "porogen" may be used to indicate micro- or nano-scale spherical or somewhat spherical particles with "hollow" centers. The hollow centers are not filled with solid material, but may rather include a gaseous or liquid core. In one embodiment, the plurality of closed cell pores is composed of pre-expanded and gas-filled EXPANCEL™ distributed throughout (e.g., as an additional component in) a homogeneous polishing body of the polishing pad. In a specific embodiment, the EXPANCEL™ is filled with pentane. In an embodiment, each of the plurality of closed cell pores has a diameter approximately in the range of 10 - 100 microns. In an embodiment, the plurality of closed cell pores includes pores that are discrete from one another. This is in contrast to open cell pores which may be connected to one another through tunnels, such as the case for the pores in a common sponge. In one embodiment, each of the closed cell pores includes a physical shell, such as a shell of a porogen, as described above. In another embodiment, however, each of the closed cell pores does not include a physical shell. In an embodiment, the plurality of closed cell pores is distributed essentially evenly throughout a thermoset polyurethane material of a homogeneous polishing body. In one embodiment, the homogeneous polishing body has a pore density approximately in the range of 6% - 50% total void volume, and possibly approximately in the range of 15% - 35% total void volume. In one embodiment, the homogeneous polishing has a porosity of the closed cell type, as described above, due to inclusion of a plurality of porogens.

In an embodiment, the homogeneous polishing body is opaque. In one embodiment, the term "opaque" is used to indicate a material that allows approximately 10% or less visible light to pass. In one embodiment, the homogeneous polishing body is opaque in most part, or due entirely to, the inclusion of an opacifying lubricant throughout (e.g., as an additional component in) the homogeneous thermoset, closed cell polyurethane material of the homogeneous polishing body. In a specific embodiment, the opacifying lubricant is a material such as, but not limited to: boron nitride, cerium fluoride, graphite, graphite fluoride, molybdenum sulfide, niobium sulfide, talc, tantalum sulfide, tungsten disulfide, or Teflon.

The sizing of the homogeneous polishing body may be varied according to application. Nonetheless, certain parameters may be used to make polishing pads including such a homogeneous polishing body compatible with conventional processing equipment or even with conventional chemical mechanical processing operations. For example, in accordance with an embodiment of the present invention, the homogeneous polishing body has a thickness approximately in the range of 1.9 - 3.3 millimeters. In one embodiment, the homogeneous polishing body has a diameter approximately in the range of 50 - 77 centimeters, and possibly approximately in the range of 25 - 107 centimeters.

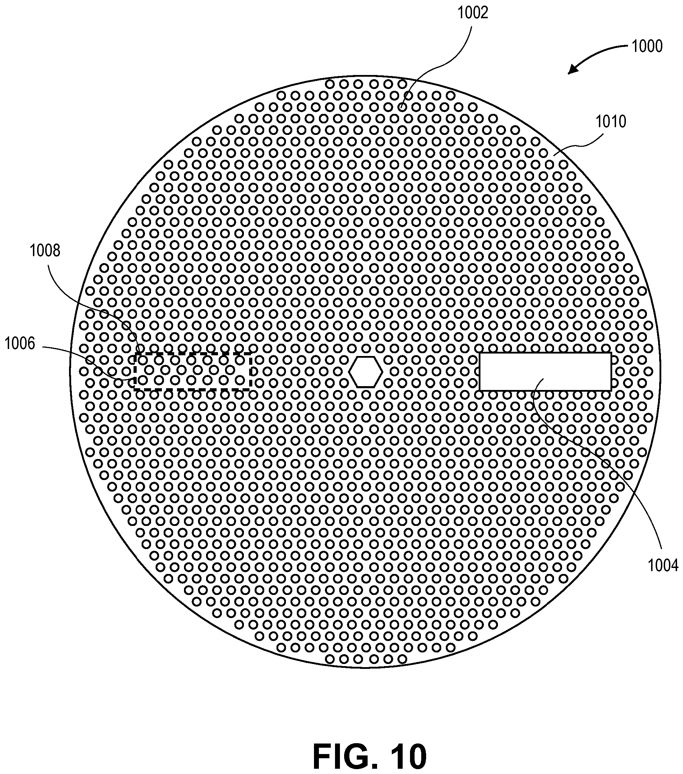

In another embodiment of the present invention, a polishing pad with a polishing surface having a plurality of continuous protrusions thereon further includes a local area transparency (LAT) region disposed in the polishing pad. For example, Figure 10 illustrates a top-down plan view of a protrusions pattern, the pattern interrupted by a local area transparency (LAT) region and/or an indication region, disposed in the polishing surface 1002 of a polishing pad 1000, in accordance with an embodiment of the present invention. Specifically, a LAT region 1004 is disposed in the polishing body of polishing pad 1000. As depicted in Figure 10, the LAT region 1004 interrupts a pattern of protrusions 1010. In an embodiment, the LAT region 1004 is disposed in, and covalently bonded with, a homogeneous polishing body of the polishing pad 1000. Examples of suitable LAT regions are described in U.S. patent application 12/657,135 filed on January 13, 2010, assigned to NexPlanar Corporation, and U.S. patent application 12/895,465 filed on September 30, 2010, assigned to NexPlanar Corporation.

In an alternative embodiment, a polishing pad described herein further includes an aperture disposed in the polishing surface and polishing body. An adhesive sheet is disposed on the back surface of the polishing body. The adhesive sheet provides an impermeable seal for the aperture at the back surface of the polishing body. Examples of suitable apertures are described in U.S. patent application 13/184,395 filed on July 15, 2011, assigned to NexPlanar Corporation.

In another embodiment, a polishing pad with a polishing surface having a pattern of continuous protrusions thereon further includes a detection region for use with, e.g., an eddy current detection system. For example, referring again to Figure 10, the polishing surface 1002 of polishing pad 1000 includes an indication region 1006 indicating the location of a detection region disposed in the back surface of the polishing pad 1000. In one embodiment, the indication region 1006 interrupts pattern of protrusions 1010 with a second pattern of protrusions 1008, as depicted in Figure 10. Examples of suitable eddy current detection regions are described in U.S. patent application 12/895,465 filed on September 30, 2010, assigned to NexPlanar Corporation.

Polishing pads described herein, such as polishing pad 200 or 800, or the above described variations thereof, may further include a foundation layer disposed on the back surface of the polishing body. In one such embodiment, the result is a polishing pad with bulk or foundation material different from the material of the polishing surface. In one embodiment, a composite polishing pad includes a foundation or bulk layer fabricated from a stable, essentially non-compressible, inert material onto which a polishing surface layer is disposed. A harder foundation layer may provide support and strength for pad integrity while a softer polishing surface layer may reduce scratching, enabling decoupling of the material properties of the polishing layer and the remainder of the polishing pad. Examples of suitable foundation layers are described in U.S. patent application 13/306,845 filed on November 29, 2011, assigned to NexPlanar Corporation.

Polishing pads described herein, such as polishing pad 200 or 800, or the above described variations thereof, may further include a sub pad disposed on the back surface of the polishing body, e.g., a conventional sub pad as known in the CMP art. In one such embodiment, the sub pad is composed of a material such as, but not limited to, foam, rubber, fiber, felt or a highly porous material.

In another aspect of the present invention, polishing a polishing surface with continuous protrusions may be fabricated in a molding process. For example, Figures 11A-11F illustrate cross-sectional views of operations used in the fabrication of a polishing pad, in accordance with an embodiment of the present invention.

Referring to Figure 11A, a formation mold 1100 is provided. Referring to Figure 11B, a pre-polymer 1102 and a curative 1104 are mixed to form a mixture 1106 in the formation mold 1100, as depicted in Figure 11C. In an embodiment, mixing the pre-polymer 1102 and the curative 1104 includes mixing an isocyanate and an aromatic diamine compound, respectively. In one embodiment, the mixing further includes adding an opacifying lubricant to the pre-polymer 1102 and the curative 1104 to ultimately provide an opaque molded homogeneous polishing body. In a specific embodiment, the opacifying lubricant is a material such as, but not limited to: boron nitride, cerium fluoride, graphite, graphite fluoride, molybdenum sulfide, niobium sulfide, talc, tantalum sulfide, tungsten disulfide, or Teflon.

In an embodiment, the polishing pad precursor mixture 1106 is used to ultimately form a molded homogeneous polishing body composed of a thermoset, closed cell polyurethane material. In one embodiment, the polishing pad precursor mixture 1106 is used to ultimately form a hard pad and only a single type of curative is used. In another embodiment, the polishing pad precursor mixture 1106 is used to ultimately form a soft pad and a combination of a primary and a secondary curative is used. For example, in a specific embodiment, the pre-polymer includes a polyurethane precursor, the primary curative includes an aromatic diamine compound, and the secondary curative includes a compound having an ether linkage. In a particular embodiment, the polyurethane precursor is an isocyanate, the primary curative is an aromatic diamine, and the secondary curative is a curative such as, but not limited to, polytetramethylene glycol, amino-functionalized glycol, or amino-functionalized polyoxypropylene. In an embodiment, the pre-polymer, a primary curative, and a secondary curative have an approximate molar ratio of 100 parts pre-polymer, 85 parts primary curative, and 15 parts secondary curative. It is to be understood that variations of the ratio may be used to provide polishing pads with varying hardness values, or based on the specific nature of the pre-polymer and the first and second curatives.

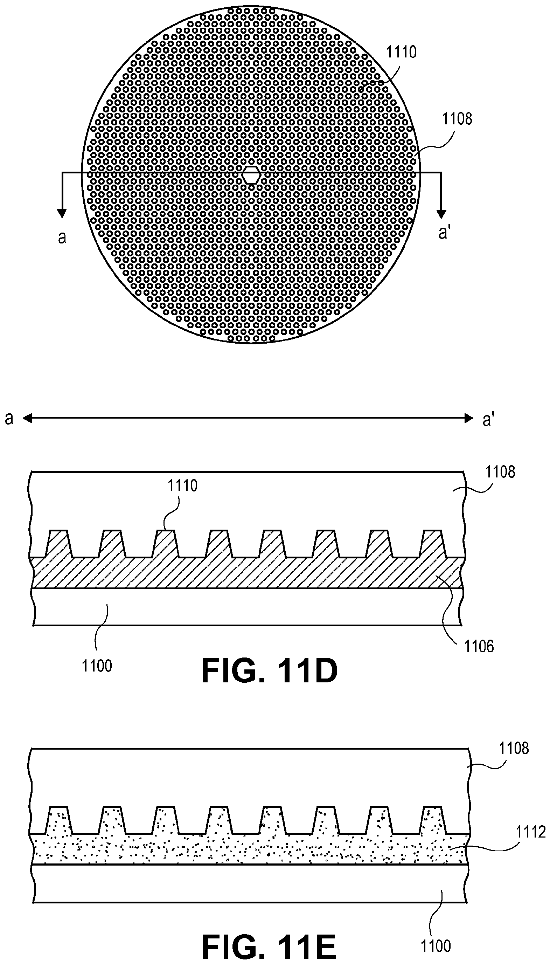

Referring to Figure 11D, a lid 1108 of the formation mold 1100 is lowered into the mixture 1106. A top-down plan view of lid 1108 is shown on top, while a cross-section along the a-a' axis is shown below in Figure 11D. In an embodiment, the lid 1108 has disposed thereon a pattern of grooves 1110, e.g., grooves with sidewalls that taper inward toward the base of the lid, as shown in Figure 11D. The pattern of grooves 1110 is used to stamp a pattern of protrusions into a polishing surface of a polishing pad formed in formation mold 1100.

It is to be understood that embodiments described herein that describe lowering the lid 1108 of a formation mold 1100 need only achieve a bringing together of the lid 1108 and a base of the formation mold 1100. That is, in some embodiments, a base of a formation mold 1100 is raised toward a lid 1108 of a formation mold, while in other embodiments a lid 1108 of a formation mold 1100 is lowered toward a base of the formation mold 1100 at the same time as the base is raised toward the lid 1108.

Referring to Figure 11E, the mixture 1106 is cured to provide a molded homogeneous polishing body 1112 in the formation mold 1100. The mixture 1106 is heated under pressure (e.g., with the lid 1108 in place) to provide the molded homogeneous polishing body 1112. In an embodiment, heating in the formation mold 1100 includes at least partially curing in the presence of lid 1108, which encloses mixture 1106 in formation mold 1100, at a temperature approximately in the range of 200 - 260 degrees Fahrenheit and a pressure approximately in the range of 2 - 12 pounds per square inch.

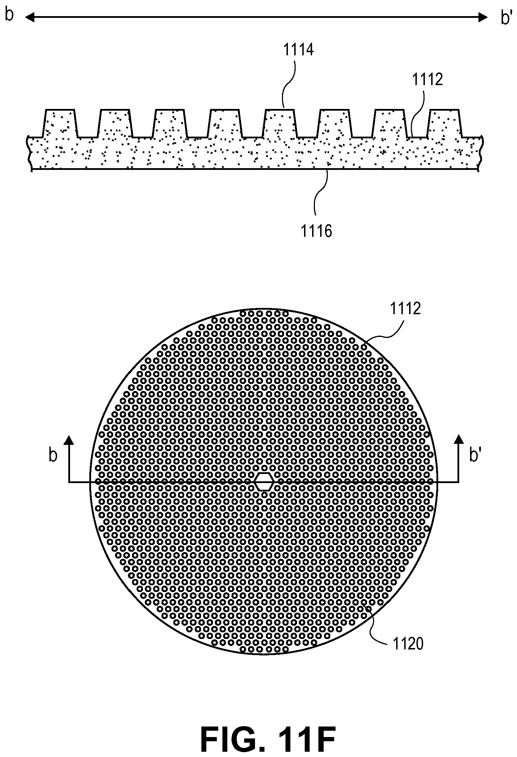

Referring to Figure 11F, a polishing pad (or polishing pad precursor, if further curing is required) is separated from lid 1108 and removed from formation mold 1100 to provide the discrete molded homogeneous polishing body 1112. A top-down plan view of molded homogeneous polishing body 1112 is shown below, while a cross-section along the b-b' axis is shown above in Figure 11F. The formed protrusions have sidewalls that taper outwardly toward the polishing pad.

It is noted that further curing through heating may be desirable and may be performed by placing the polishing pad in an oven and heating. Thus, in one embodiment, curing the mixture 1106 includes first partially curing in the formation mold 1100 and then further curing in an oven. Either way, a polishing pad is ultimately provided, wherein a molded homogeneous polishing body 1112 of the polishing pad has a polishing surface 1114 and a back surface 1116. In an embodiment, the molded homogeneous polishing body 1112 is composed of a thermoset polyurethane material and a plurality of closed cell pores disposed in the thermoset polyurethane material. The molded homogeneous polishing body 1112 includes a polishing surface 1114 having disposed therein a pattern of protrusions 1120 corresponding to the pattern of grooves 1110 of the lid 1108. The pattern of protrusions 1120 may be a pattern of protrusions as described above, e.g., with respect to Figures 2A-2G, 3A, 3B, 4, 5A-5C, 6A-6D, 7, 8A-8C, 9A and 9B.

In an embodiment, referring again to Figure 11B, the mixing further includes adding a plurality of porogens 1122 to the pre-polymer 1102 and the curative 1104 to provide closed cell pores in the ultimately formed polishing pad. Thus, in one embodiment, each closed cell pore has a physical shell. In another embodiment, referring again to Figure 11B, the mixing further includes injecting a gas 1124 into to the pre-polymer 1102 and the curative 1104, or into a product formed there from, to provide closed cell pores in the ultimately formed polishing pad. Thus, in one embodiment, each closed cell pore has no physical shell. In a combination embodiment, the mixing further includes adding a plurality of porogens 1122 to the pre-polymer 1102 and the curative 1104 to provide a first portion of closed cell pores each having a physical shell, and further injecting a gas 1124 into the pre-polymer 1102 and the curative 1104, or into a product formed there from, to provide a second portion of closed cell pores each having no physical shell. In yet another embodiment, the pre-polymer 1102 is an isocyanate and the mixing further includes adding water (H₂O) to the pre-polymer 1102 and the curative 1104 to provide closed cell pores each having no physical shell.

Thus, protrusion patterns contemplated in embodiment of the present invention may be formed in-situ. For example, as described above, a compression-molding process may be used to form polishing pads with a polishing surface having a pattern of continuous protrusions having tapered sidewalls. By using a molding process, highly uniform protrusion dimensions within-pad may be achieved. Furthermore, extremely reproducible protrusion dimensions along with very smooth, clean protrusion surfaces may be produced. Other advantages may include reduced defects and micro-scratches and a greater usable protrusion depth. In a particularly useful embodiment, by forming the protrusions to have outwardly tapering sidewalls, demolding from a manufacturing mold during the molding process is facilitated. For example, the corresponding grooves in the molding lid widen as they approach the outer most portion of the pattern. The widened outer portion of the lid which corresponds to the plurality of protrusions can provide for ease of removal of the molded, either partially or fully cured, polishing pad from the pattern of the mold.

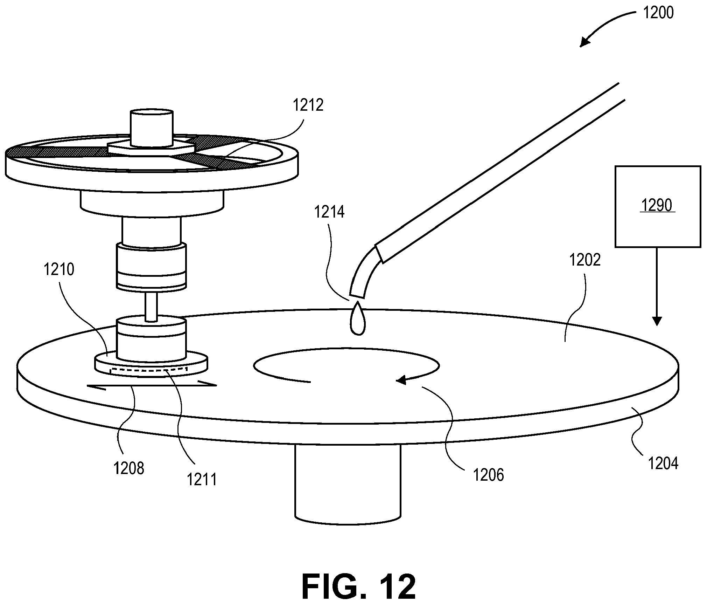

Polishing pads described herein may be suitable for use with a variety of chemical mechanical polishing apparatuses. As an example, Figure 12 illustrates an isometric side-on view of a polishing apparatus compatible with a polishing pad having a polishing surface with continuous protrusions having tapered sidewalls, in accordance with an embodiment of the present invention.

Referring to Figure 12, a polishing apparatus 1200 includes a platen 1204. The top surface 1202 of platen 1204 may be used to support a polishing pad with a pattern of polishing protrusions thereon. Platen 1204 may be configured to provide spindle rotation 1206 and slider oscillation 1208. A sample carrier 1210 is used to hold, e.g., a semiconductor wafer 1211 in place during polishing of the semiconductor wafer with a polishing pad. Sample carrier 1210 is further supported by a suspension mechanism 1212. A slurry feed 1214 is included for providing slurry to a surface of a polishing pad prior to and during polishing of the semiconductor wafer. A conditioning unit 1290 may also be included and, in one embodiment, includes a diamond tip for conditioning a polishing pad.

Thus, polishing pads having a polishing surface with continuous protrusions having tapered sidewalls have been disclosed. In accordance with an embodiment of the present invention, a polishing pad for polishing a substrate includes a polishing body having a polishing side opposite a back surface. The polishing pad also includes a polishing surface having a plurality of protrusions continuous with the polishing side of the polishing body. Each protrusion has a flat surface distal from the polishing body and sidewalls tapered outwardly from the flat surface toward the polishing body. In one embodiment, the sidewalls of each protrusion are planar. In one embodiment, the sidewalls of each protrusion are curved. In one embodiment, the sidewalls of each protrusion are stepped.

## Claims

1. A polishing pad for polishing a substrate, the polishing pad comprising:
a polishing body having a polishing side opposite a back surface; and
a polishing surface comprising a plurality of protrusions (202, 702) continuous with the polishing side of the polishing body, each protrusion comprising a flat surface distal from the polishing body and sidewalls tapered outwardly from the flat surface toward the polishing body,
**characterized in that**:
the plurality of protrusions is arranged in a hexagonal-packed pattern; and
the polishing pad further comprises a solid ring (206) encompassing the plurality of protrusions at an outer most edge of the polishing side of the polishing body, the solid ring continuous with the polishing side of the polishing body and having an irregular shape that follows a contour of the hexagonal-packed pattern of the plurality of protrusions, wherein the hexagonal-packed pattern of the plurality of protrusions is interrupted by a plurality of larger spacings (706) within the solid ring.

2. The polishing pad of claim 1, wherein the sidewalls of each protrusion are:
planar; or
curved; or
stepped.

3. The polishing pad of claim 1, wherein the sidewalls of each protrusion are planar and are tapered with an angle of less than approximately 30 degrees to normal of the polishing surface of the polishing body.

4. The polishing pad of claim 3, wherein the sidewalls are tapered with an angle approximately in the range of 0.1 - 10 degrees to normal of the polishing surface of the polishing body.

5. The polishing pad of claim 1, wherein the flat surface of each of the plurality of protrusions has a shape that is selected from the group consisting of a circle, an oval, and a polygon.

6. The polishing pad of claim 1,
wherein the hexagonal-packed pattern of the plurality of protrusions terminates proximate to the ring in a staggered arrangement.

7. The polishing pad of claim 1, further comprising:
a button region disposed centrally within the hexagonal-packed pattern of the plurality of protrusions, the button region having a hexagonal shape, optionally wherein the button region further comprises a triangular clocking mark on one side of the hexagonal shape.

8. The polishing pad of claim 1, wherein the protrusions are arranged such that:
the plurality of protrusions is arranged in a plurality of high density regions having less spacing between adjacent protrusions within a high density region than between adjacent protrusions of adjacent high density regions; or
each of the plurality of protrusions has a maximum lateral dimension approximately in the range of 1 - 30 millimeters proximate to the polishing body, with a spacing between one another approximately in the range of 0.1 - 3 millimeters proximate to the polishing body; or
the flat surface of each protrusion of a first portion of the plurality of protrusions has a first shape, and the flat surface of each protrusion of a second portion of the plurality of protrusions has a second, different, shape; or
the total surface area of the plurality of protrusions is a portion approximately in the range of 40-80% of the total surface area of the polishing side of the polishing body; or
the height of each of the plurality of protrusions is approximately in the range of 0.5 - 1 millimeter; or
the plurality of protrusions comprises approximately between 50,000 - 200,000 protrusions for a polishing pad having a diameter approximately in the range of 73.6- 81.3 cm (29 - 32 inches); or
the plurality of protrusions has a randomized pattern; or
each protrusion of a first portion of the plurality of protrusions has a first height from the polishing body, and each protrusion of a second portion of the plurality of protrusions has a second, different, height from the polishing body, but all of the plurality of protrusions are substantially co-planar distal from the polishing body; or
for each protrusion, a portion of each of the sidewalls undercuts the flat surface.

9. The polishing pad of claim 1, wherein each protrusion of a first portion of the plurality of protrusions has a first maximum lateral dimension proximate to the polishing body, and each protrusion of a second portion of the plurality of protrusions has a second, different, maximum lateral dimension proximate to the polishing body, optionally wherein a pattern of the plurality of protrusions comprises a protrusion having a maximum lateral dimension of approximately 10 millimeters proximate to the polishing body surrounded by a plurality of protrusions each having a maximum lateral dimension of approximately 1 millimeter proximate to the polishing body.

10. The polishing pad of claim 1, wherein the polishing body and polishing surface are together homogeneous and unitary.

11. The polishing pad of claim 1, wherein the polishing body and polishing surface are together homogeneous and unitary and comprise a molded polyurethane material, optionally wherein the molded polyurethane material has a pore density of closed cell pores approximately in the range of 6% - 50% total void volume.

12. The polishing pad of claim 1, further comprising either:
a foundation layer disposed on the back surface of the polishing body; or
a detection region disposed in the back surface of the polishing body.

13. The polishing pad of claim 1, further comprising:
an aperture disposed in the polishing surface and polishing body; and
an adhesive sheet disposed on the back surface of the polishing body, the adhesive sheet providing an impermeable seal for the aperture at the back surface of the polishing body.

14. The polishing pad of claim 1, further comprising:
a sub pad disposed on the back surface of the polishing body.

15. The polishing pad of claim 1, further comprising:
a local area transparency (LAT) region disposed in the polishing body, the LAT region interrupting a pattern of the plurality of protrusions.

## Patentansprüche

1. Polierpad zum Polieren eines Substrats, wobei das Polierpad Folgendes umfasst:
einen Polierkörper mit einer Polierseite gegenüber einer Rückenfläche; und
eine Polieroberfläche, die eine Vielzahl von Vorsprüngen (202, 702) umfasst, die mit der Polierseite des Polierkörpers durchgehend sind, wobei jeder Vorsprung eine flache Oberfläche distal vom Polierkörper und Seitenwände aufweist, die sich von der flachen Oberfläche zum Polierkörper hin nach außen verjüngen,
**dadurch gekennzeichnet, dass**:
die Vielzahl von Vorsprüngen in einem hexagonal gepackten Muster angeordnet ist; und
das Polierpad ferner einen massiven Ring (206) umfasst, der die Vielzahl von Vorsprüngen an einer äußersten Kante der Polierseite des Polierkörpers umfasst, wobei der massive Ring mit der Polierseite des Polierkörpers durchgehend ist und eine unregelmäßige Form aufweist, die einer Kontur des hexagonal gepackten Musters der Vielzahl von Vorsprüngen folgt, wobei das hexagonal gepackte Muster der Vielzahl von Vorsprüngen durch eine Vielzahl von größeren Abständen (706) innerhalb des massiven Rings unterbrochen ist.

2. Polierpad nach Anspruch 1, wobei die Seitenwände jedes Vorsprungs Folgendes sind:
ebenflächig; oder
gekrümmt; oder
abgestuft.

3. Polierpad nach Anspruch 1, wobei die Seitenwände jedes Vorsprungs ebenflächig sind und mit einem Winkel von weniger als etwa 30 Grad bis zur Senkrechten der Polieroberfläche des Polierkörpers verjüngt sind.

4. Polierpad nach Anspruch 3, wobei die Seitenwände mit einem Winkel im Bereich von etwa 0,1 - 10 Grad bis zur Senkrechten der Polieroberfläche des Polierkörpers verjüngt sind.

5. Polierpad nach Anspruch 1, wobei die flache Oberfläche von jedem der Vielzahl von Vorsprüngen eine Form aufweist, die aus der Gruppe ausgewählt ist, die aus einem Kreis, einem Oval und einem Polygon besteht.

6. Polierpad nach Anspruch 1,
wobei das hexagonal gepackte Muster der Vielzahl von Vorsprüngen in der Nähe des Rings in einer versetzten Anordnung endet.

7. Polierpad nach Anspruch 1, das ferner Folgendes umfasst:
eine Knopfregion, die im hexagonal gepackten Muster der Vielzahl von Vorsprüngen mittig angeordnet ist, wobei die Knopfregion eine hexagonale Form aufweist, wobei die Knopfregion optional ferner eine dreieckige Taktungsmarkierung auf einer Seite der hexagonal Form aufweist.

8. Polierpad nach Anspruch 1, wobei die Vorsprünge so angeordnet sind, dass:
die Vielzahl von Vorsprüngen in einer Vielzahl von Bereichen hoher Dichte angeordnet ist, die weniger Abstand zwischen benachbarten Vorsprüngen innerhalb eines Bereichs hoher Dichte aufweisen als zwischen benachbarten Vorsprüngen von benachbarten Bereichen hoher Dichte; oder
jeder der Vielzahl von Vorsprüngen eine maximale seitliche Abmessung in der Nähe des Polierkörpers im Bereich von etwa 1-30 Millimetern aufweist, wobei der Abstand zwischen diesen im Bereich von 0,1-3 Millimetern in der Nähe des Polierkörpers liegt; oder
die flache Oberfläche jedes Vorsprungs eines ersten Abschnitts der Vielzahl von Vorsprüngen eine erste Form aufweist und die flache Oberfläche jedes Vorsprungs eines zweiten Abschnitts der Vielzahl von Vorsprüngen eine zweite unterschiedliche Form aufweist; oder
die Gesamtoberfläche der Vielzahl von Vorsprüngen ein Abschnitt ist, der ungefähr im Bereich von 40-80 % der Gesamtoberfläche der Polierseite des Polierkörpers liegt; oder
die Höhe von jedem der Vielzahl von Vorsprüngen ungefähr im Bereich von 0,5-1 Millimetern liegt; oder
die Vielzahl der Vorsprünge ungefähr zwischen 50.000-200.000 Vorsprünge für ein Polierpad mit einem Durchmesser von ungefähr 73,6- 81,3 cm (29 - 32 Zoll) umfasst; oder
die Vielzahl der Vorsprünge ein zufälliges Muster aufweist; oder
jeder Vorsprung eines ersten Abschnitts der Vielzahl von Vorsprüngen eine erste Höhe vom Polierkörper aufweist und jeder Vorsprung eines zweiten Abschnitts der Vielzahl von Vorsprüngen eine zweite unterschiedliche Höhe vom Polierkörper aufweist, jedoch alle der Vielzahl von Vorsprüngen distal vom Polierkörper im Wesentlichen koplanar sind; oder
für jeden Vorsprung ein Abschnitt jeder der Seitenwände die flache Oberfläche unterschneidet.

9. Polierpad nach Anspruch 1, wobei jeder Vorsprung eines ersten Abschnitts der Vielzahl von Vorsprüngen eine erste maximale seitliche Abmessung in der Nähe des Polierkörpers aufweist und jeder Vorsprung eines zweiten Abschnitts der Vielzahl von Vorsprüngen eine zweite unterschiedliche maximale seitliche Abmessung in der Nähe des Polierkörpers aufweist, wobei optional ein Muster der Vielzahl von Vorsprüngen einen Vorsprung mit einer maximalen seitlichen Abmessung von ungefähr 10 Millimetern in der Nähe des Polierkörpers umfasst, der von einer Vielzahl von Vorsprüngen umgeben ist, die jeweils eine maximale seitliche Abmessung von ungefähr 1 Millimeter in der Nähe des Polierkörpers aufweisen.

10. Polierpad nach Anspruch 1, wobei der Polierkörper und die Polieroberfläche zusammen homogen und einheitlich sind.

11. Polierpad nach Anspruch 1, wobei der Polierkörper und die Polierfläche zusammen homogen und einheitlich sind und ein geformtes Polyurethanmaterial umfassen, wobei das geformte Polyurethanmaterial optional eine Porendichte der geschlossenen Zellporen im Bereich von etwa 6 % - 50 % des gesamten Hohlraumvolumens aufweist.

12. Polierpad nach Anspruch 1, ferner umfassend entweder:
eine Grundschicht, die auf der Rückenfläche des Polierkörpers angeordnet ist; oder
eine Erfassungsregion, die in der Rückenfläche des Polierkörpers angeordnet ist.

13. Polierpad nach Anspruch 1, das ferner Folgendes umfasst:
eine Öffnung, die in der Polieroberfläche und im Polierkörper angeordnet ist; und
eine Klebefolie, die auf der Rückenfläche des Polierkörpers angeordnet ist, wobei die Klebefolie eine undurchdringliche Dichtung für die Öffnung an der Rückenfläche des Polierkörpers bereitstellt.

14. Polierpad nach Anspruch 1, das ferner Folgendes umfasst:
ein Unterpad, das auf der Rückenfläche des Polierkörpers angeordnet ist.

15. Polierpad nach Anspruch 1, das ferner Folgendes umfasst:
eine Lokalbereichstransparanz(LAT)-Region, die im Polierkörper angeordnet ist, wobei die LAT-Region ein Muster der Vielzahl von Vorsprüngen unterbricht.

## Revendications

1. Tampon de polissage pour polir un substrat, le tampon de polissage comprenant :
un corps de polissage ayant un côté de polissage opposé à une surface arrière ; et
une surface de polissage comprenant une pluralité de saillies (202, 702) continues avec le côté de polissage du corps de polissage, chaque saillie comprenant une surface plate distale à partir du corps de polissage et des parois latérales effilées vers l'extérieur à partir de la surface plate vers le corps de polissage,
**caractérisé en ce que** :
la pluralité de saillies est agencée selon un motif hexagonal compact ; et le tampon de polissage comprend en outre un anneau solide (206) englobant la pluralité de saillies sur un bord le plus extérieur du côté de polissage du corps de polissage, l'anneau solide continuant avec le côté de polissage du corps de polissage et ayant une forme irrégulière qui suit un contour du motif hexagonal compact de la pluralité de saillies, dans lequel le motif hexagonal compact de la pluralité de saillies est interrompu par une pluralité d'espacements plus grands (706) à l'intérieur de l'anneau solide.

2. Tampon de polissage selon la revendication 1, dans lequel les parois latérales de chaque saillie sont :
planaires ; ou
incurvées ; ou
étagées.

3. Tampon de polissage selon la revendication 1, dans lequel les parois latérales de chaque saillie sont planes et sont effilées avec un angle inférieur à environ 30 degrés par rapport à la normale de la surface de polissage du corps de polissage.

4. Tampon de polissage selon la revendication 3, dans lequel les parois latérales sont effilées avec un angle approximativement dans la plage de 0,1 à 10 degrés par rapport à la normale de la surface de polissage du corps de polissage.

5. Tampon de polissage selon la revendication 1, dans lequel la surface plate de chacune de la pluralité de saillies a une forme qui est choisie dans le groupe constitué d'un cercle, d'un ovale et d'un polygone.

6. Tampon de polissage selon la revendication 1,
dans lequel le motif hexagonal de la pluralité de saillies se termine à proximité de l'anneau dans un agencement en quinconce.

7. Tampon de polissage selon la revendication 1, comprenant en outre :
une région de bouton disposée de manière centrale dans le motif hexagonal compact de la pluralité de saillies, la région de bouton ayant une forme hexagonale, éventuellement dans laquelle la région de bouton comprend en outre une marque d'horloge triangulaire sur un côté de la forme hexagonale.

8. Tampon de polissage selon la revendication 1, dans lequel les saillies sont disposées de telle sorte que :
la pluralité de saillies est agencée dans une pluralité de régions à haute densité ayant moins d'espacement entre les saillies adjacentes dans une région à haute densité qu'entre les saillies adjacentes de régions à haute densité adjacentes ; ou
chacune de la pluralité de saillies a une dimension latérale maximale approximativement dans la plage de 1 à 30 millimètres à proximité du corps de polissage, avec un espacement entre elles approximativement dans la plage de 0,1 à 3 millimètres à proximité du corps de polissage ; ou
la surface plate de chaque saillie d'une première partie de la pluralité de saillies a une première forme, et la surface plate de chaque saillie d'une deuxième partie de la pluralité de saillies a une deuxième forme différente ; ou
la surface totale de la pluralité de saillies est une partie approximativement dans la plage de 40 à 80% de la surface totale du côté de polissage du corps de polissage ; ou
la hauteur de chacune de la pluralité de saillies est approximativement dans la plage de 0,5 à 1 millimètre ; ou
la pluralité de saillies comprend approximativement entre 50 000 et 200 000 saillies pour un tampon de polissage ayant un diamètre approximativement compris dans la plage de 73,6 à 81,3 cm (29 à 32 pouces) ; ou
la pluralité de saillies a un motif aléatoire ; ou
chaque saillie d'une première partie de la pluralité de saillies a une première hauteur par rapport au corps de polissage, et chaque saillie d'une deuxième partie de la pluralité de saillies a une deuxième hauteur différente du corps de polissage, mais la totalité de la pluralité des saillies sont sensiblement coplanaires distales à partir du corps de polissage ; ou
pour chaque saillie, une partie de chacune des parois latérales sape la surface plate.

9. Tampon de polissage selon la revendication 1, dans lequel chaque saillie d'une première partie de la pluralité de saillies a une première dimension latérale maximale à proximité du corps de polissage, et chaque saillie d'une deuxième partie de la pluralité de saillies a une deuxième dimension latérale maximale différente à proximité du corps de polissage, éventuellement dans laquelle un motif de la pluralité de saillies comprend une saillie ayant une dimension latérale maximale d'environ 10 millimètres à proximité du corps de polissage entourée par une pluralité de saillies ayant chacune une dimension latérale maximale d'environ 1 millimètre à proximité du corps de polissage.

10. Tampon de polissage selon la revendication 1, dans lequel le corps de polissage et la surface de polissage sont à la fois homogènes et unitaires.

11. Tampon de polissage selon la revendication 1, dans lequel le corps de polissage et la surface de polissage sont à la fois homogènes et unitaires et comprennent un matériau en polyuréthane moulé, éventuellement dans lequel le matériau en polyuréthane moulé a une densité de pores de pores à cellules fermées approximativement dans la plage de 6% à 50% du volume de vide total.

12. Tampon de polissage selon la revendication 1, comprenant en outre :
une couche de fondation disposée sur la surface arrière du corps de polissage ; ou
une région de détection disposée dans la surface arrière du corps de polissage.

13. Tampon de polissage selon la revendication 1, comprenant en outre :
une ouverture disposée dans la surface de polissage et le corps de polissage ; et
une feuille adhésive disposée sur la surface arrière du corps de polissage, la feuille adhésive fournissant un joint imperméable pour l'ouverture à la surface arrière du corps de polissage.

14. Tampon de polissage selon la revendication 1, comprenant en outre :
un sous-tampon disposé sur la surface arrière du corps de polissage.

15. Tampon de polissage selon la revendication 1, comprenant en outre :
une région de transparence de zone locale (LAT) disposée dans le corps de polissage, la région LAT interrompant un motif de la pluralité de saillies.
